# EUROPÄISCHE PATENTSCHRIFT

(11) **EP 0 487 869 B1**
(45) Veröffentlichungstag und Bekanntmachung des Hinweises auf die Patenterteilung: **12.02.1997**
(21) Anmeldenummer: 91117112.2
(22) Anmeldetag: 08.10.1991
(51) Int. Cl.: H01L 29/74

(54) **Abschaltbares Leistungshalbleiter-Bauelement**
Turn-off power semiconductor device
Dispositif semi-conducteur de puissance, à extinction

(30) Priorität: 29.11.1990 CH 3783/90
(43) Veröffentlichungstag der Anmeldung: 03.06.1992
(73) Patentinhaber: ASEA BROWN BOVERI AG, 5401 Baden (CH)
(72) Erfinder: Lilja, Klas, CH-5442 Fislisbach (CH)

(56) Entgegenhaltungen:
- EP-A- 0 106 059
- EP-A- 0 454 201
- IEEE TRANSACTIONS ON ELECTRON DEVICES. Bd. ED-33, Nr. 10, Oktober 1986, NEWYORK US Seiten 1609 - 1618; V. A. K. TEMPLE: 'MOS-controlled thyristors - A newclass of power devices'

## Beschreibung

### TECHNISCHES GEBIET

Die vorliegende Erfindung bezieht sich auf das Gebiet der Leistungselektronik. Sie betrifft insbesondere ein abschaltbares Leistungshalbleiter-Bauelement nach dem Oberbegriff des ersten Anspruchs.

Ein solches Bauelement ist z.B. aus einem Artikel von V. A. K. Temple, IEEE Transactions on Electron Devices, Vol. ED-33, No. 10, October 1986, S.1609-1618 als MOS-gesteuerter Thyristor (MCT) bekannt.

### STAND DER TECHNIK

Die moderne Leistungselektronik fordert heute schnelle, mit einfachen Mitteln ansteuerbare Halbleiterbauelemente, die bis zu den höchsten Leistungsbereichen einsetzbar sind.

Steuerbare Halbleiterbauelemente für höchste Leistungen sind heute die GTO(Gate Turn Off)-Thyristoren. Im Prinzip unterteilt man beim GTO die gesamte Chipfläche in eine Vielzahl von parallel geschalteten Elementarzellen. Ueber den Gatekontakt können diese Bauelemente ein- und ausgeschaltet werden; wegen der hohen Gateströme beim Abschalten ist dabei allerdings ein enormer Schaltungsaufwand für die Gateansteuerung in Kauf zu nehmen.

Seit einigen Jahren ist in der Leistungselektronik daher zunehmend die Entwicklung von MOS-gesteuerten Bauelementen vorangetrieben worden. Der Vorteil dieser MOS-gesteuerten Bauelemente liegt hauptsächlich in der hohen Eingangsimpedanz an der Steuerelektrode begründet. Sie ermöglicht die Ansteuerung des Bauelements mit einem vergleichsweise sehr geringen Aufwand an Leistung.

Eingeleitet wurde dieser Trend von den unipolaren Leistungs-MOSFETs mit DMOS-Struktur. Diese DMOSFETs haben jedoch einen gewichtigen Nachteil: Hohe Durchbruchspannungen müssen bei diesen Bauelementen wegen des unipolaren Leitungscharakters mit hohen Durchlasswiderständen erkauft werden, welche die maximale Stromstärke begrenzen.

Höhere schaltbare Leistungen sind bekanntermassen nur mit Bipolarstrukturen (z.B. Thyristoren) erreichbar. Dennoch soll bei derartigen Bipolarstrukturen möglichst an der einfachen und insbesondere leistungsarmen Steuerung, welche man bei den Leistungs-MOSFETs verwendet, festhalten werden.

Es ist deshalb vorgeschlagen worden, das beschriebene Konzept der Steuerung von Leistungshalbleiter-Bauelementen über MOS-Gates auch bei Bauelementen der höchsten Leistungsklasse, nämlich bei Thyristoren, zu verwirklichen (siehe dazu den eingangs genannten Artikel von V. A. K. Temple).

Bei einem derartigen MOS-gesteuerten Thyristor oder MCT (MOS Controlled Thyristor), der wie der GTO aus einer Vielzahl von nebeneinanderliegenden, parallelgeschalteten Einheitszellen besteht, wird das Abschalten über einen Kurzschluss des Emitters mit der p-Basis durch schaltbare Emittershorts erreicht. Als Schalter dienen dabei mit dem Emitter integrierte MOSFETs, die naturgemäss wahlweise als n- oder p-Kanal-MOSFETs ausgebildet sein können.

Bei feinstrukturierten Thyristoren vom Typ des MCT oder GTO können allerdings während des Abschaltens extrem inhomogene Stromdichteverteilungen (Filamente) auftreten (siehe dazu: K. Lilja und H. Grüning, "Onset of Current Filamentation in GTO Devices", PESC '90, Power Electronics Specialist Conference, S.398-406 (1990)). Dabei führt ein kleiner Spannungszuwachs in der P-Basisschicht zu einem exponentiellen Anwachsen der Elektroneninjektion von der Kathode. Es kommt dadurch unter normalen Bedingungen zwangsläufig zu einer Umverteilung und Filamentierung des Stromes, die das Bauelement zerstören kann.

Eine änhnliche Fünfschicht-Thyristorstruktur, von der sich der Gegenstand des Anspruchs 1 durch eine p⁺ dotierte Basisschicht und eine n⁺-dotierte Emitterschicht unterscheidet, ist aus dem Dokument EP-A-454201 bekannt, das unter Artikel 54(3) EPÜ fällt.

### DARSTELLUNG DER ERFINDUNG

Es ist daher Aufgabe der Erfindung, ein bipolares, durch ein isoliertes Gate steuerbares Leistungshalbleiter-Bauelement zu schaffen, welches frei von Filamentierungs-Effekten höchste Leistungen zu schalten vermag.

Die Aufgabe wird bei einem Bauelement der eingangs genannten Art durch die Merkmale des unabhängigen Anspruchs 1 bzw. 5 gelöst.

Der Kern der Erfindung besteht darin, zwischen der Anode und der Kathode anstelle der üblichen bipolaren, aus vier Schichten bestehenden p-n-p-n-Thyristorstruktur nunmehr eine Fünfschicht-Struktur vorzusehen, wobei als fünfte Schicht auf der Kathodenseite ein direkt mit der Kathode verbundenes, p⁺-dotiertes Kontaktgebiet angeordnet ist.

Im Durchlassbetrieb wird das Kontaktgebiet durch einen MOSFET überbrückt. Beim Abschalten dagegen liegt diese zusätzliche Schicht zwischen der Kathode und der p-n-p-n-Thyristorstruktur und verhindert wirksam die zur Filamentierung führende Elektroneninjektion.

Gemäss einer ersten Ausführungsform der Erfindung umfassen das Leistunshalbleiter-Bauelement einen zweiten MOSFET, welcher aus dem Kontaktgebiet, der n-Emitterschicht, der p-Basisschicht und einer über der n-Emitterschicht angeordneten zweiten Gateelektrode gebildet wird.

Durch Einschalten dieses zweiten MOSFET werden beim Abschalten die von der Anode injizierten Löcher abgeführt und damit wirksam ein Avalanche-Durchbruch zwischen dem Kontaktgebiet und der n-Emitterschicht verhindert.

Eine zweite Ausführungsform zeichnet sich dadurch aus, dass ein parasitärer bipolarer Transistor vorgesehen ist, welcher aus der fünften Schicht, der n-Emitterschicht und der p-Basisschicht gebildet wird, wobei die n-Emitterschicht die Funktion der Basis des bipolaren Transistors übernimmt wobei der bipolare Transistor beim Abschalten durch einen Avalanche-Durchbruch zwischen dem Kontaktgebiet und der n-Emitterschicht eingeschaltet wird.

In dieser Ausführungsform übernimmt der bipolare Transistor, der beim Abschalten automatisch durchgesteuert wird, die Funktion des zweiten MOSFET.

Weiter Ausführungsformen ergeben sich aus den Unteransprüchen.

### KURZE BESCHREIBUNG DER ZEICHNUNG

Die Erfindung soll nachfolgend im Zusammenhang mit der Zeichnung anhand von Ausführungsbeispielen näher erläutert werden. Es zeigen
- Fig. 1: im Querschnitt die Einheitszelle eines Bauelements gemäss einer ersten bevorzugten Ausführungsform des erfindungsgemässen Bauelements mit zwei MOSFETs;
- Fig. 2: im Querschnitt die Einheitszelle eines Bauelements gemäss einer zweiten bevorzugten Ausführungsform des erfindungsgemässen Bauelements mit drei MOSFETs, von denen der dritte zum Einschalten verwendet wird;
- Fig. 3: im Querschnitt die Einheitszelle einer mit Fig. 2 vergleichbaren Ausführungsform, bei der alle drei MOSFETs nebeneinander auf einer Seite angeordnet sind;
- Fig. 4: im Querschnitt die Einheitszelle einer mit Fig. 1 vergleichbaren Ausführungsform, bei welcher der zweite MOSFET durch einen parasitären Bipolartransistor ersetzt ist;
- Fig. 5: das Ersatzschaltbild eines Bauelements gemäss Fig. 1;
- Fig. 6: den Verlauf eines beispielhaften Dotierungsprofils entlang dem Schnitt B-B in Fig. 1; und
- Fig. 7: den Verlauf eines beispielhaften Dotierungsprofils entlang dem Schnitt A-A in Fig. 1.

### WEGE ZUR AUSFÜHRUNG DER ERFINDUNG

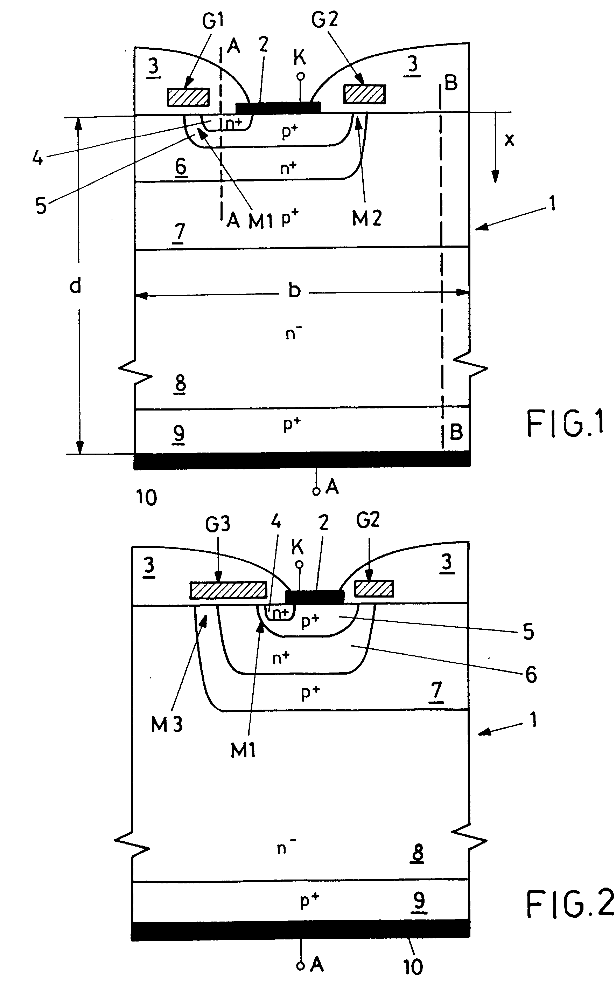

In Fig. 1 ist im Querschnitt die Einheitszelle einer bevorzugten Ausführungsform des Bauelements nach der Erfindung dargestellt. Das Bauelement ist generell ein fünf Schichten umfassender, über ein isoliertes Gate gesteuerter, bipolarer Schalter und soll daher nachfolgend kurz als IG-FiBS (Insulated Gate controlled Five layer Bipolar Switch) bezeichnet werden.

In der gezeigten Ausführungsform besteht der IG-FiBS aus einem Halbleitersubstrat 1 mit einer oberen und einer unteren Hauptfläche. Die untere Hauptfläche ist mit einem Anodenkontakt 10 versehen, der mit der Anode A in Verbindung steht. Die obere Hauptfläche trägt innerhalb jeder Einheitszelle einen Kathodenkontakt 2, der seinerseits mit der Kathode K in Verbindung steht.

Zwischen dem Anodenkontakt 10 und dem Kathodenkontakt 2 ist innerhalb des Halbleitersubstrats 1 eine Schichtenfolge von fünf mit wechselnder Polarität dotierten Schichten angeordnet, welche aufeinanderfolgend eine p⁺-dotierte p-Emitterschicht 9, eine n⁻-dotierte n-Basisschicht 8, eine p⁺-dotierte p-Basisschicht 7, eine n⁺-dotierte n-Emitterschicht 6 und ein p⁺-dotiertes Kontaktgebiet 5 umfasst. Die p-Emitterschicht 9 wird dabei von dem Anodenkontakt 10 kontaktiert, das Kontaktgebiet 5 auf der anderen Seite des Halbleitersubstrats vom Kathodenkontakt 2.

Seitwärts vom Kathodenkontakt 2 ist auf der einen Seite ein erster MOSFET M1 und auf der anderen Seite ein zweiter MOSFET M2 in das Halbleitersubstrat 1 integriert.

Der erste MOSFET M1 wird aus der n-Emitterschicht 6, dem Kontaktgebiet 5, einem in das Kontaktgebiet 5 eingelassenen, mit dem Kathodenkontakt 2 verbundenen, n⁺-dotierten Sourcegebiet 4 und einer oberhalb des Kontaktgebietes 5 isoliert (Gateisolierung 3) angeordneten ersten Gateelektrode G1 gebildet. Er ist ein n-Kanal-MOSFET, dessen Kanalgebiet Teil des zwischen n-Emitterschicht 6 und Sourcegebiet 4 an die obere Hauptfläche tretenden Kontaktgebietes 5 ist.

Der zweite MOSFET M2 wird aus der p-Basisschicht 7, der n-Emitterschicht 6, dem Kontaktgebiet 5 und einer oberhalb der n-Emitterschicht 6 isoliert (Gateisolierung 3) angeordneten zweiten Gateelektrode G2 gebildet. Er ist ein p-Kanal-MOSFET, dessen Kanalgebiet Teil der zwischen dem wannenförmigen Kontaktgebiet 5 und der p-Basisschicht 7 an die obere Hauptfläche tretenden n-Emitterschicht 6 ist.

Die Parameter der Einheitszelle der Ausführungsform aus Fig. 1 können beispielsweise wie folgt gewählt werden: Die Einheitszelle hat eine Breite b von etwa 20 µm. Die Dicke d des Halbleitersubstrats 1 beträgt dabei ungefähr 420 µm.

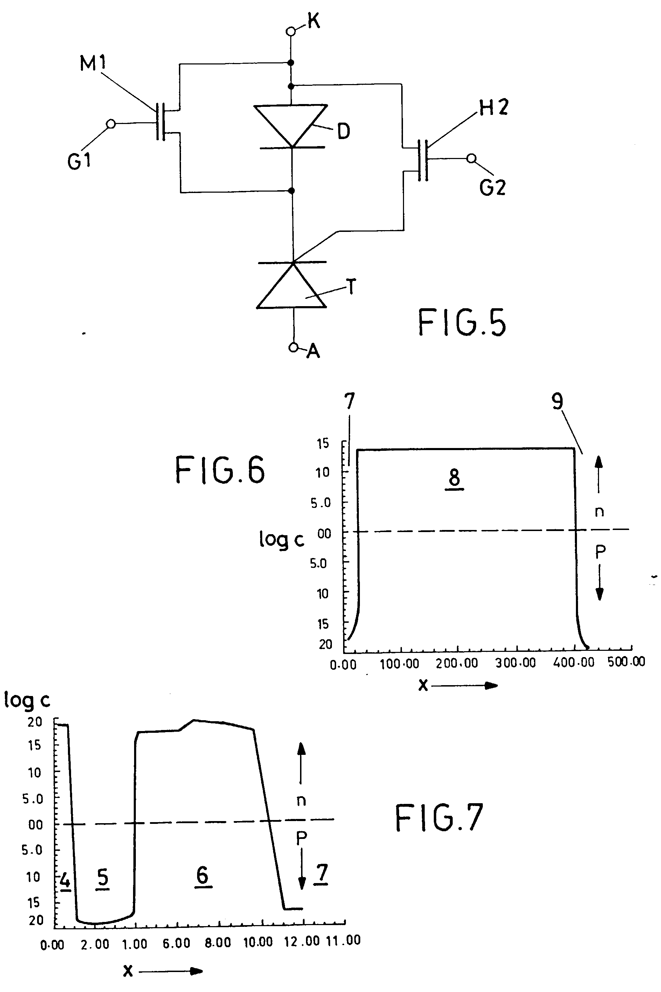

Der Verlauf der Dotierungskonzentration c (in cm⁻³), der sich entlang der in Fig. 1 eingezeichneten Schnittlinien A-A und B-B ergibt, ist in Fig. 7 (Schnitt A-A) und in Fig. 6 (Schnitt B-B) in logarithmischer Auftragung in Abhängigkeit vom Abstand x von der Substratoberfläche (siehe Fig. 1) wiedergegeben. Die Dotierungskonzentration für n-dotiertes Material ist dabei von der gestrichelten Null-Linie nach oben, die entsprechende Dotierungskonzentration für p-dotiertes Material nach unten abgetragen. Man kann den Figuren 6 und 7 entnehmen, dass in diesem Beispiel die n-Basisschicht 8 z.B. eine Dotierungskonzentration von etwa 5x10¹³ cm⁻³ hat, während die n-Emitterschicht 6 eine Dotierungskonzentration um etwa 10¹⁸ cm⁻³ und das p-dotierte Kontaktgebiet 5 eine Dotierungskonzentration von etwa 10¹⁹ cm⁻³ aufweist.

Das Bauelement gemäss Fig. 1 kann in einem Ersatzschaltbild (Fig. 5) als antiparallele Serieschaltung aus einer Diode D und einem Thyristor T aufgefasst werden, wobei die Diode D durch den ersten MOSFET M1 überbrückt werden kann, während der zweite MOSFET M2 zwischen die Kathode K und das Gate des Thyristors T geschaltet ist.

Die Funktion des Bauelements gemäss Fig. 1 ist die folgende: Im eingeschalteten Zustand (ON-State) hat die erste Gateelektrode G1 relativ zur Kathode K eine positive Gatespannung. Der erste MOSFET M1 ist damit eingeschaltet und schliesst den Kathodenkontakt 2 mit der n-Emitterschicht 6 kurz, die für das übrige Bauelement als Emitter wirkt. Durch den Kurzschluss reduziert sich die aktive Struktur des Bauelements auf eine p-n-p-n-Folge von vier Schichten (p-Emitterschicht 9, n-Basisschicht 8, p-Basisschicht 7 und n-Emitterschicht 6), die sich - abgesehen von dem Kanalwiderstand des ersten MOSFET, der sehr klein gemacht werden kann - wie ein herkömmlicher Thyristor verhält. Der zweite MOSFET M2 ist in dieser Phase gesperrt.

Um nun das Bauelement abzuschalten, wird die Gatespannung an der ersten Gateelektrode G1 reduziert, sodass der erste MOSFET M1 in den gesperrten Zustand übergeht. Hierdurch wird der IG-FiBS von der Vierschicht- in eine Fünfschicht(p-n-p-n-p)-Struktur überführt und schaltet ab. Es ist festzuhalten, dass durch das zusätzliche p-dotierte Kontaktgebiet 5 die Elektroneninjektion von der Kathodenseite her grundsätzlich vollständig aufhört.

Gleichzeitig mit dem Sperren des ersten MOSFET M1 wird der zweite MOSFET M2 eingeschaltet, der dann den vollen Abschaltstrom übernimmt. Dies ist notwendig, um einen Avalanche-Durchbruch am PN-Uebergang zwischen dem Kontaktgebiet 5 und der n-Emitterschicht 6 zu verhindern. Dieser PN-Uebergang hat nämlich eine ziemlich geringe Durchbruchspannung (in der Grössenordnung von 10-20 V), die weit unterhalb der Sperrfähigkeit des gesamten Bauelements liegt. Ein Avalanche-Durchbruch an diesem PN-Uebergang würde dann ein Abschalten des Bauelements verhindern oder zumindest den Abschaltprozess beträchtlich verlangsamen.

Unter Bezugnahme auf die Erklärungen der Strom-Umverteilung, wie sie für den GTO und den MCT in dem eingangs genannten Artikel von K. Lilja und H. Grüning gegeben worden sind, kann nun leicht erläutert werden, warum der IG-FiBS gemäss der Erfindung keine Probleme mit einer Filamentierung des Stromes hat: In einem GTO oder MCT führt eine geringe Zunahme der Spannung an der p-Basisschicht (entspricht der p-Basisschicht 7 in Fig. 1) während des Abschaltvorgangs zu einem exponentiellen Ansteigen der Elektroneninjektion von der Kathode K. Wie in dem zitierten Artikel beschrieben, zieht dies notwendigerweise eine Strom-Umverteilung und -Filamentierung nach sich (es sei denn, es gelte die spezielle Bedingung β_{eff} < β_{crit}).

In dem IG-FiBS dagegen wird beim Abschalten die Kathode durch das p-dotierte Kontaktgebiet 5 gebildet. Aus diesem Grunde ist eine Elektroneninjektion überhaupt nicht möglich. Vielmehr resultiert eine Zunahme der Spannung oder des Stromes in der IG-FiBS-Struktur während des Abschaltens in einem schnelleren Abbau der gespeicherten Ladungsträger, d.h. in einem schnelleren Turn-Off. Der IG-FiBS ist daher selbst-stabilisierend.

Die in Fig. 1 dargestellte Struktur umfasst die beiden MOSFETs M1 und M2, die beide - wie oben erläutert - für den Abschaltvorgang notwendig sind. Für das Einschalten des Bauelements kann dann ein dritter MOSFET M3 (Fig. 2) vorgesehen werden. Dieser dritte MOSFET M3 wird durch die n-Basisschicht 8, die p-Basisschicht 7, die n-Emitterschicht 6 und eine weitere, über der p-Basisschicht 7 isoliert angeordnete Gateelektrode gebildet. Diese weitere Gateelektrode kann - wie in Fig. 2 gezeigt - mit der ersten Gateelektrode G1 zu einer gemeinsamen dritten Gateelektrode G3 zusammengefasst werden. Der erste und der dritte MOSFET M1 und M3 sind auf diese Weise nebeneinander integriert und elektrisch hintereinander geschaltet.

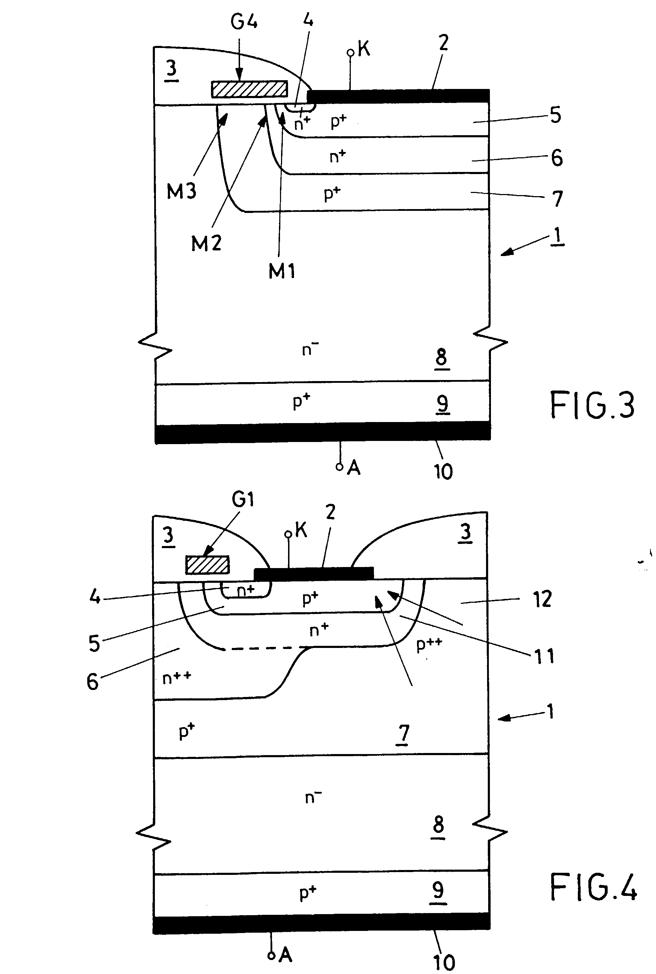

Bei einer weiteren Ausführungsform (Fig. 3) sind die drei MOSFETs M1, M2 und M3 auf derselben Seite nebeneinander angeordnet und hintereinander geschaltet. Die Gateelektroden der drei MOSFETs sind dann zu einer gemeinsamen vierten Gateelektrode G4 zusammengefasst.

An dieser Stelle sei darauf hingewiesen, dass im Rahmen der Erfindung auch andere Anordnungen und Aufteilungen der MOSFETs M1, M2 und M3 möglich sind. So ist es insbesondere denkbar, den ersten MOSFET M1 auf der einen Seite des Kathodenkontakts anzuordnen, und die MOSFETs M2 und M3 auf der anderen Seite zusammenzufassen. Ebenso ist es denkbar, anstelle des dritten MOSFET M3 andere bekannte Mittel zum Einschalten des Bauelements vorzusehen.

Eine weitere, in Fig. 4 wiedergegebene Ausführungsform stellt eine Variante zu der in Fig. 1 gezeigten Ausführungsform dar. Anstelle des zweiten MOSFET M2 wird hier ein aus Kontaktgebiet 5, n-Emitterschicht 6 und p-Basisschicht 7 gebildeter, bipolarer, parasitärer p-n-p-Transistor verwendet, der durch einen gewollten Avalanche-Durchbruch gezündet wird und dann den Abschaltstrom (in Fig. 4 angedeutet durch die beiden Pfeile) übernimmt.

Der gewollte Durchbruch findet in dem PN-Uebergang zwischen dem Kontaktgebiet 5 und der n-Emitterschicht 6 statt. Die n-Emitterschicht 6 läuft dazu zur oberen Hauptfläche des Halbleitersubstrats 1 hin in einem schmalen, geringer dotierten (n+ statt n++) Basisgebiet 11 aus, dem ein stärker dotiertes (p++ statt p+) Teilgebiet 12 der p-Basisschicht 7 benachbart ist. Der bipolare Transistor hat auf diese Weise eine hohe Stromverstärkung β und kann leicht durch einen Durchbruch in diesem Bereich eingeschaltet werden. Die übrigen Teile der Struktur erfüllen die gleichen Aufgaben wie bei der Ausführungsform gemäss Fig. 1.

In gleicher Weise kann daher auch ein weiterer MOSFET zum Einschalten vorgesehen und mit dem ersten MOSFET M1, ähnlich wie in Fig. 2, zusammengefasst werden.

Zum Schluss seien noch einige Anmerkungen hinsichtlich der verwendeten MOSFETs angefügt:
- Der erste MOSFET M1 ist ein n-Kanal-MOSFET. Er hat daher einen Kanalwiderstand, der etwa dreimal kleiner ist, als der eines entsprechenden P-Kanal-MOSFET.
- Der zweite MOSFET M2 hat den ausschliesslichen Zweck, einen Avalanche-Durchbruch am PN-Uebergang vom Kontaktgebiet 5 zur n-Emitterschicht 6 zu verhindern. Um dies zu gewährleisten, muss er beim Abschalten den gesamten Abschaltstrom führen. Dies stellt jedoch kein Problem dar, da die treibende Spannung (Source-Drain-Spannung) - anders als beim MOSFET eines MCT, wo sie lediglich bei 0,7 bis 0,8 V liegt - hier 10 V oder mehr betragen kann.
- Der IG-FiBS ist insgesamt nicht so sehr auf eine perfekte Technologie angewiesen wie der MCT. Wenn z.B. bei einem grossflächigen Bauelement einige der ersten MOSFETs M1 nicht arbeiten (fehlerhaft sind), können die zugehörigen Einheitszellen überhaupt nicht eingeschaltet werden, d.h. sie sind automatisch passiviert. Der IG-FiBS ist daher -zumindestens was die ersten MOSFETs M1 anbelangt - "selbstreparierend".
   Die zweiten MOSFETs M2 dagegen müssen in jeder Einheitszelle einsatzfähig sein. Da jedoch ihr einziger Zweck die Verhinderung des Avalanche-Durchbruchs ist, müssen sie nicht notwendig überall perfekt sein. Wenn z.B. der zweite MOSFET M2 so ausgelegt ist, dass er den vollen Strom bei einer Source-Drain-Spannung von 1 V führt, und der Avalanche-Durchbruch zwischen dem Kontaktgebiet 5 und der n-Emitterschicht 6 planmässig bei einer Spannung von 15 V stattfindet, bleibt für den zweiten MOSFET M2 ein Toleranzbereich von 1 bis 15 V, der auch mit einer weniger anspruchsvollen Technologie leicht eingehalten werden kann.

Die bisherigen Ausführungen haben sich auf ein Bauelement mit p-n-p-n-p-Schichtenfolge bezogen, bei welcher die einzelnen Schichten und Gebiete eine Dotierung eines bestimmten Typs aufweisen. Es liegt aber auch im Rahmen der Erfindung, alle Schichten 6, 7, 8 und 9 und Gebiete 4, 5 innerhalb des Halbleitersubstrats 1 durch entsprechende Schichten und Gebiete mit komplementärer Dotierung zu ersetzen; die p⁺-dotierte p-Emitterschicht 9 wird dann umgewandelt in eine n⁺-dotierte n-Emitterschicht, die n-dotierte n-Basisschicht 8 in eine p-dotierte p-Basisschicht, usw..

Insgesamt ergibt sich mit der Erfindung ein leicht ansteuerbares, sicher abschaltbares Hochleistungs-Bauelement, bei welchem eine Filamentierung des Stromes beim Abschalten vermieden wird, und welches sich vergleichsweise einfach herstellen lässt.

## Patentansprüche

1. Abschaltbares Leistungshalbleiter-Bauelement, umfassend
(a) in einem Halbleitersubstrat (1) zwischen einer Anode (A) und einer Kathode (K) eine Vielzahl von nebeneinander angeordneten, elektrisch parallel geschalteten Einheitszellen;
(b) innerhalb jeder Einheitszelle zwischen der Anode (A) und der Kathode (K) eine Schichtenfolge von mehreren aufeinanderfolgenden, mit abwechselnder Polarität dotierten Schichten; und
(c) innerhalb jeder Einheitszelle ein auf der Kathodenseite angeordneter, erster MOSFET (M1), welcher zum Abschalten des Bauelements vorgesehen ist;
dadurch gekennzeichnet, dass
(d) die Schichtenfolge fünf Schichten umfasst, von denen die erste Schicht als eine p⁺-dotierte p-Emitterschicht (9), die zweite Schicht als eine n⁻-dotierte n-Basisschicht (8), die dritte Schicht als eine p⁺-dotierte p-Basisschicht (7), die vierte Schicht als eine n⁺-dotierte n-Emitterschicht (6) und die fünfte Schicht als ein p⁺-dotiertes Kontaktgebiet (5) ausgeführt sind;
(e) die p-Emitterschicht (9) auf der Anodenseite angeordnet und durch einen Anodenkontakt (10) kontaktiert wird, und das Kontaktgebiet (5) auf der Kathodenseite angeordnet und durch einen Kathodenkontakt (2) kontaktiert wird;
(f) der erste MOSFET (M1) eine schaltbare Verbindung zwischen der n-Emitterschicht (6) und dem Kathodenkontakt (2) herstellt und aus der n-Emitterschicht (6), dem Kontaktgebiet (5), einem n⁺-dotierten und mit dem Kathodenkontakt (2) verbundenen Sourcegebiet (4) und einer über dem Kontaktgebiet (5) isoliert angeordneten ersten Gateelektrode (G1) gebildet wird; und
(g) ein zweiter MOSFET (M2) vorgesehen ist, welcher aus dem Kontaktgebiet (5), der n-Emitterschicht (6), der p-Basisschicht (7) und einer über der n-Emitterschicht (6) angeordneten zweiten Gateelektrode (G2) gebildet wird und beim Abschalten eine Verbindung zwischen dem Kontaktgebiet (5) und der p-Basisschicht (7) herstellt.

2. Bauelement nach Anspruch 1, dadurch gekennzeichnet, dass
(a) innerhalb jeder Einheitszelle auf der Kathodenseite ein dritter MOSFET (M3) zum Einschalten des Bauelements vorgesehen ist; und
(b) der dritte MOSFET (M3) eine schaltbare Verbindung zwischen der n-Basisschicht (8) und der n-Emitterschicht (6) herstellt und aus der n-Basisschicht (8), der p-Basisschicht (7), der n-Emitterschicht (6) und einer über der n-Emitterschicht (6) angeordneten Gateelektrode gebildet wird.

3. Bauelement nach Anspruch 2, dadurch gekennzeichnet, dass
(a) der erste MOSFET (M1) und der dritte MOSFET (M3) nebeneinander angeordnet und hintereinandergeschaltet sind; und
(b) die erste Gateelektrode (G1) und die Gateelektrode des dritten MOSFET (M3) zu einer gemeinsamen dritten Gateelektrode (G3) zusammengefasst sind.

4. Bauelement nach Anspruch 3, dadurch gekennzeichnet, dass
(a) der erste MOSFET (M1), der zweite MOSFET (M2) und der dritte MOSFET (M3) nebeneinander angeordnet und hintereinandergeschaltet sind; und
(b) die erste Gateelektrode (G1), die zweite Gateelektrode (G2) und die Gateelektrode des dritten MOSFET (M3) zu einer gemeinsamen vierten Gateelektrode (G4) zusammengefasst sind.

5. Abschaltbares Leistungshalbleiter-Bauelement, umfassend
(a) in einem Halbleitersubstrat (1) zwischen einer Anode (A) und einer Kathode (K) eine Vielzahl von nebeneinander angeordneten, elektrisch parallel geschalteten Einheitszellen;
(b) innerhalb jeder Einheitszelle zwischen der Anode (A) und der Kathode (K) eine Schichtenfolge von mehreren aufeinanderfolgenden, mit abwechselnder Polarität dotierten Schichten; und
(c) innerhalb jeder Einheitszelle ein auf der Kathodenseite angeordneter, erster MOSFET (M1), welcher zum Abschalten des Bauelements vorgesehen ist;
dadurch gekennzeichnet, dass
(d) die Schichtenfolge fünf Schichten umfasst, von denen die erste Schicht als eine p⁺-dotierte p-Emitterschicht (9), die zweite Schicht als eine n⁻-dotierte n-Basisschicht (8), die dritte Schicht als eine p⁺-dotierte p-Basisschicht (7), die vierte Schicht als eine n⁺-dotierte n-Emitterschicht (6) und die fünfte Schicht als ein p⁺-dotiertes Kontaktgebiet (5) ausgeführt sind;
(e) die p-Emitterschicht (9) auf der Anodenseite angeordnet und durch einen Anodenkontakt (10) kontaktiert wird, und das Kontaktgebiet (5) auf der Kathodenseite angeordnet und durch einen Kathodenkontakt (2) kontaktiert wird;
(f) der erste MOSFET (M1) eine schaltbare Verbindung zwischen der n-Emitterschicht (6) und dem Kathodenkontakt (2) herstellt und aus der n-Emitterschicht (6), dem Kontaktgebiet (5), einem n⁺-dotierten und mit dem Kathodenkontakt (2) verbundenen Sourcegebiet (4) und einer über dem Kontaktgebiet (5) isoliert angeordneten ersten Gateelektrode (G1) gebildet wird; und
(g) ein parasitärer bipolarer Transistor vorgesehen ist, welcher aus der fünften Schicht, der n-Emitterschicht (6) und der p-Basisschicht (7) gebildet wird und welcher beim Abschalten eine leitende Verbindung zwischen dem Kontaktgebiet (5) und der p-Basisschicht (7) herstellt, wobei die n-Emitterschicht (6) die Funktion der Basis des bipolaren Transistors übernimmt, und der bipolare Transistor beim Abschalten durch einen Avalanche-Durchbruch zwischen dem Kontaktgebiet (5) und der n-Emitterschicht (6) eingeschaltet wird.

6. Bauelement nach Anspruch 5, dadurch gekennzeichnet, dass
(a) innerhalb jeder Einheitszelle auf der Kathodenseite ein weiterer MOSFET zum Einschalten des Bauelements vorgesehen ist; und
(b) der weitere MOSFET eine schaltbare Verbindung zwischen der n-Basisschicht (8) und der n-Emitterschicht (6) herstellt und aus der n-Basisschicht (8), der p-Basisschicht (7), der n-Emitterschicht (6) und einer über der n-Emitterschicht (6) angeordneten Gateelektrode gebildet wird.

7. Bauelement nach Anspruch 6, dadurch gekennzeichnet, dass
(a) der erste MOSFET (M1) und der weitere MOSFET nebeneinander angeordnet und hintereinandergeschaltet sind; und
(b) die erste Gateelektrode (G1) und die Gateelektrode des weiteren MOSFET zu einer gemeinsamen Gateelektrode zusammengefasst sind.

8. Bauelement nach einem der Ansprüche 1 bis 7, dadurch gekennzeichnet, dass alle Schichten (6,7,8,9) und Gebiete (4,5) innerhalb des Halbleitersubstrats (1) durch entsprechende Schichten und Gebiete mit komplementärer Dotierung ersetzt sind.

## Claims

1. Controlled turn-off power semiconductor device, comprising
(a) a multiplicity of adjacently arranged, electrically parallel-connected unit cells in a semiconductor substrate (1) between an anode (A) and a cathode (K);
(b) a layer sequence of a plurality of successive layers doped with alternating polarity within each unit cell between the anode (A) and the cathode (K); and
(c) within each unit cell, a first MOSFET (M1) which is arranged on the cathode side and which is provided for turning off the device;
characterized in that
(d) the layer sequence comprises five layers, of which the first layer is formed as a p⁺-doped p-type emitter layer (9), the second layer as an n⁻-doped n-type base layer (8), the third layer as a p⁺-doped p-type base layer (7), the fourth layer as an n⁺-doped n-type emitter layer (6) and the fifth layer as a p⁺-doped contact region (5);
(e) the p-type emitter layer (9) is arranged on the anode side and is contacted by an anode contact (10), and the contact region (5) is arranged on the cathode side and is contacted by a cathode contact (2);
(f) the first MOSFET (M1) produces a switchable connection between the n-type emitter layer (6) and the cathode contact (2) and is formed from the n-type emitter layer (6), the contact region (5), an n⁺-doped source region (4) connected to the cathode contact (2) and a first gate electrode (G1) arranged in an insulated fashion above the contact region (5); and
(g) a second MOSFET (M2) is provided which is formed from the contact region (5), the n-type emitter layer (6), the p-type base layer (7) and a second gate electrode (G2) arranged above the n-type emitter layer (6) and produces a connection between the contact region (5) and the p-type base layer (7) during turning-off.

2. Device according to Claim 1, characterized in that
(a) a third MOSFET (M3) for turning on the device is provided on the cathode side inside every unit cell; and
(b) the third MOSFET (M3) produces a switchable connection between the n-type base layer (8) and the n-type emitter layer (6) and is formed from the n-type base layer (8), the p-type base layer (7), the n-type emitter layer (6) and a gate electrode arranged above the n-type emitter layer (6).

3. Device according to Claim 2, characterized in that
(a) the first MOSFET (M1) and the third MOSFET (M3) are adjacently arranged and connected in series; and
(b) the first gate electrode (G1) and the gate electrode of the third MOSFET (M3) are combined to form a common third gate electrode (G3).

4. Device according to Claim 3, characterized in that
(a) the first MOSFET (M1), the second MOSFET (M2) and the third MOSFET (M3) are adjacently arranged and connected in series; and
(b) the first gate electrode (G1), the second gate electrode (G2) and the gate electrode of the third MOSFET (M3) are combined to form a common fourth gate electrode (G4).

5. Controlled turn-off power semiconductor device, comprising
(a) a multiplicity of adjacently arranged, electrically parallel-connected unit cells in a semiconductor substrate (1) between an anode (A) and a cathode (K);
(b) a layer sequence of a plurality of successive layers doped with alternating polarity within each unit cell between the anode (A) and the cathode (K); and
(c) within each unit cell, a first MOSFET (M1) which is arranged on the cathode side and which is provided for turning off the device;
characterized in that
(d) the layer sequence comprises five layers, of which the first layer is formed as a p⁺-doped p-type emitter layer (9), the second layer as an n⁻-doped n-type base layer (8), the third layer as a p⁺-doped p-type base layer (7), the fourth layer as an n⁺-doped n-type emitter layer (6) and the fifth layer as a p⁺-doped contact region (5);
(e) the p-type emitter layer (9) is arranged on the anode side and is contacted by an anode contact (10), and the contact region (5) is arranged on the cathode side and is contacted by a cathode contact (2);
(f) the first MOSFET (M1) produces a switchable connection between the n-type emitter layer (6) and the cathode contact (2) and is formed from the n-type emitter layer (6), the contact region (5), an n⁺-doped source region (4) connected to the cathode contact (2) and a first gate electrode (G1) arranged in an insulated fashion above the contact region (5); and
(g) a parasitic bipolar transistor is provided which is formed from the fifth layer, the n-type emitter layer (6) and the p-type base layer (7) and which produces a conducting connection between the contact region (5) and the p-type base layer (7) during turning-off, the n-type emitter layer (6) taking on the function of the base of the bipolar transistor, and the bipolar transistor being turned on by an avalanche breakdown between the contact region (5) and the n-type emitter layer (6) during turning-off.

6. Device according to Claim 5, characterized in that
(a) a further MOSFET for turning on the device is provided on the cathode side inside every unit cell; and
(b) the further MOSFET produces a switchable connection between the n-type base layer (8) and the n-type emitter layer (6) and is formed from the n-type base layer (8), the p-type base layer (7), the n-type emitter layer (6) and a gate electrode arranged above the n-type emitter layer (6).

7. Device according to Claim 6, characterized in that
(a) the first MOSFET (M1) and the further MOSFET are adjacently arranged and connected in series; and
(b) the first gate electrode (G1) and the gate electrode of the further MOSFET are combined to form a common gate electrode.

8. Device according to any of Claims 1 to 7, characterized in that all the layers (6, 7, 8, 9) and regions (4, 5) inside the semiconductor substrate (1) are replaced by corresponding layers and regions with complementary doping.

## Revendications

1. Dispositif semi-conducteur de puissance à extinction, comportant
a) dans un substrat semi-conducteur (1), entre une anode (A) et une cathode (K), une multiplicité de cellules unitaires disposées l'une à côté de l'autre et branchées électriquement en parallèle ;
b) à l'intérieur de chaque cellule unitaire, entre l'anode (A) et la cathode (K), une succession de plusieurs couches se suivant l'une l'autre et dopées selon une polarité alternée ; et
c) à l'intérieur de chaque cellule unitaire, un premier MOSFET (M1) disposé du côté cathode, qui est prévu pour l'extinction du dispositif ;
caractérisé en ce que
d) la succession de couches comporte cinq couches dont la première couche est réalisée en couche (9) d'émetteur p dopée p⁺, la seconde couche en couche (8) de base n dopée n⁻, la troisième couche en couche (7) de base p dopée p⁺, la quatrième couche en couche (6) d'émetteur n dopée n⁺ et la cinquième couche en zone de contact (5) dopée p⁺ ;
e) la couche (9) d'émetteur p est disposée du côté de l'anode et est contactée par un contact d'anode (10) et la zone de contact (5) est disposée du côté de la cathode et est contactée par un contact de cathode (2) ;
f) le premier MOSFET (M1) établit une liaison commutable entre la couche (6) d'émetteur n et le contact de cathode (2) et est formé par la couche (6) d'émetteur n, la zone de contact (5), une zone de source (4) dopée n⁺ et reliée au contact de cathode (2), et une première électrode de grille (G1) disposée de manière isolée au-dessus de la zone de contact (5) ; et
g) un second MOSFET (M2) est prévu qui est formé par la zone de contact (5), la couche (6) d'émetteur n, la couche (7) de base p et une seconde électrode de grille (G2) disposée au-dessus de la couche (6) d'émetteur n et qui établit une liaison entre la zone de contact (5) et la couche (7) de base p lors de l'extinction.

2. Dispositif selon la revendication 1 caractérisé en ce que
a) à l'intérieur de chaque cellule unitaire, du côté de la cathode, il est prévu un troisième MOSFET (M3) pour l'allumage du dispositif ; et
b) le troisième MOSFET (M3) établit une liaison commutable entre la couche (8) de base n et la couche (6) d'émetteur n et est formé par la couche (8) de base n, la couche (7) de base p, la couche (6) d'émetteur n et une électrode de grille disposée au-dessus de la couche (6) d'émetteur n.

3. Dispositif selon la revendication 2 caractérisé en ce que
a) le premier MOSFET (M1) et le troisième MOSFET (M3) sont disposés l'un à côté de l'autre et branchés l'un derrière l'autre ; et
b) la première électrode de grille (G1) l'électrode de grille du troisième MOSFET (M3) sont regroupées en une troisième électrode de grille (G3) commune.

4. Dispositif selon la revendication 3 caractérisé en ce que
a) le premier MOSFET (M1), le second MOSFET (M2) et le troisième MOSFET (M3) sont disposés l'un à côté de l'autre et branchés l'un derrière l'autre ; et
b) la première électrode de grille (G1), la seconde électrode de grille (G2) et l'électrode de grille du troisième MOSFET (M3) sont regroupées en une quatrième électrode de grille (G4) commune.

5. Dispositif semi-conducteur de puissance à 5 extinction, comportant
a) dans un substrat semi-conducteur (1), entre une anode (A) et une cathode (K), une multiplicité de cellules unitaires disposées l'une à côté de l'autre et branchées électriquement en parallèle ;
b) à l'intérieur de chaque cellule unitaire, entre l'anode (A) et la cathode (K), une succession de plusieurs couches se suivant l'une l'autre et dopées selon une polarité alternée ; et
c) à l'intérieur de chaque cellule unitaire, un premier MOSFET (M1) disposé du côté cathode, qui est prévu pour l'extinction du dispositif ;
caractérisé en ce que
d) la succession de couches comporte cinq couches dont la première couche est réalisée en couche (9) d'émetteur p dopée p⁺, la seconde couche en couche (8) de base n dopée n⁻, la troisième couche en couche (7) de base p dopée p⁺, la quatrième couche en couche (6) d'émetteur n dopée n⁺ et la cinquième couche en zone de contact (5) dopée p⁺;
e) la couche (9) d'émetteur p est disposée du côté de l'anode et est contactée par un contact d'anode (10) et la zone de contact (5) est disposée du côté de la cathode et est contactée par un contact de cathode (2) ;
f) le premier MOSFET (M1) établit une liaison commutable entre la couche (6) d'émetteur n et le contact de cathode (2) et est formé par la couche (6) d'émetteur n, la zone de contact (5), une zone de source (4) dopée n⁺ et reliée au contact de cathode (2), et une première électrode de grille (G1) disposée de manière isolée au-dessus de la zone de contact (5) ; et
g) un transistor bipolaire parasite est prévu qui est formé par la cinquième couche, la couche (6) d'émetteur n et la couche (7) de base p, et qui établit une liaison conductrice entre la zone de contact (5) et la couche (7) de base p lors de l'extinction, la couche (6) d'émetteur n assumant la fonction de la base du transistor bipolaire, et le transistor bipolaire étant allumé lors de l'extinction par un amorçage par avalanche entre la zone de contact (5) et la couche (6) d'émetteur n.

6. Dispositif selon la revendication 5 caractérisé en ce que
a) à l'intérieur de chaque cellule unitaire, du côté de la cathode, il est prévu un MOSFET supplémentaire pour l'allumage du dispositif ; et
b) le MOSFET supplémentaire établit une liaison commutable entre la couche (8) de base n et la couche (6) d'émetteur n et est formé par la couche (8) de base n, la couche (7) de base p, la couche (6) d'émetteur n et une électrode de grille disposée au-dessus de la couche (6) d'émetteur n.

7. Dispositif selon la revendication 6 caractérisé en ce que
a) le premier MOSFET (M1) et le MOSFET supplémentaire sont disposés l'un à côté de l'autre et branchés l'un derrière l'autre ; et
b) la première électrode de grille (G1) l'électrode de grille du MOSFET supplémentaire sont regroupées en une électrode de grille (G3) commune.

8. Dispositif selon l'une quelconque des revendications 1 à 7 caractérisé en ce que toutes les couches (6, 7, 8, 9) et les zones (4, 5) à l'intérieur du substrat semi-conducteur (1) sont remplacées par des couches et des zones correspondantes avec un dopage complémentaire.
